(19) Europäisches Patentamt / European Patent Office / Office européen des brevets

(11) **EP 1 337 038 B1**

(12) **FASCICULE DE BREVET EUROPEEN**

(45) Date de publication et mention de la délivrance du brevet:
**02.06.2010 Bulletin 2010/22**

(51) Int Cl.:
*H03G 3/30* (2006.01)      *H03F 3/189* (2006.01)
*H01P 5/18* (2006.01)

(21) Numéro de dépôt: **03290354.4**

(22) Date de dépôt: **14.02.2003**

(54) **Boucle d'asservissement en puissance, circuit d'amplification de signaux radiofréquences et émetteur de signaux radiofréquences équipé d'un tel circuit**

Schleife zur Leistungsregelung, Schaltung zur Verstärkung von Hochfrequenzsignalen und Hochfrequenzsender mit einer solchen Schaltung

Power control loop, radiofrequency amplifying circuit, and transmitter for radiofrequency signals having such a circuit

(84) Etats contractants désignés:
**AT BE BG CH CY CZ DE DK EE ES FI FR GB GR HU IE IT LI LU MC NL PT SE SI SK TR**

(30) Priorité: **19.02.2002 FR 0202090**

(43) Date de publication de la demande:
**20.08.2003 Bulletin 2003/34**

(73) Titulaire: **IPG Electronics 504 Limited**
**St Peter Port**
**Guernsey GY1 3QL (GB)**

(72) Inventeurs:
• **Kolodziej, Pierre**
  **77167 Bagneaux/Loing (FR)**
• **Pouliquen, Mikael**
  **75015 Paris (FR)**

(74) Mandataire: **Talbot-Ponsonby, Clare Josephine**
**Coller IP Management Limited**
**Fugro House**
**Hithercroft Road**
**Wallingford**
**Oxfordshire OX10 9RB (GB)**

(56) Documents cités:
EP-A- 0 790 503      US-A- 4 122 400
US-A- 4 353 037      US-A- 4 729 129

**Description**

La présente invention se rapporte au domaine des transmissions de signaux radiofréquences et concerne plus particulièrement une boucle d'asservissement en puissance, pour commander un amplificateur de puissance notamment.

De manière connue, dans un système de télécommunications reliant un émetteur de signaux radiofréquences à un récepteur de tels signaux, il faut assurer une qualité de service maximale. Par exemple, dans le cas d'une transmission de signaux numériques, cette condition requiert que le taux d'erreurs binaires soit toujours inférieur à un taux requis. Pour satisfaire à cette condition en réception, on s'assure qu'à tout instant, le rapport signal à bruit reçu soit supérieur à une valeur prédéterminée.

Pour permettre une montée en puissance des signaux radiofréquences à émettre, l'émetteur est pourvu d'un amplificateur de puissance. Dans le cas, par exemple, d'une communication entre un terminal mobile et une station de base d'un réseau cellulaire de type GSM (Global System for Mobile communications en anglais), cet amplificateur de puissance a pour objectif d'émettre à une puissance suffisante pour que la station de base correspondante puisse recevoir de façon correcte selon les spécifications en vigueur. De cette façon, lorsque cette station de base se trouve à une distance du terminal telle qu'elle reçoit peu ou ne reçoit plus les informations de communication du terminal, la station émet une indication au terminal d'émettre à une puissance supérieure déterminée par la station.

Aussi, dans un émetteur, il est connu d'asservir l'amplificateur au moyen d'une boucle d'asservissement en puissance régulant en sortie de l'amplificateur la puissance des signaux radiofréquences à émettre.

Plus précisément, un signal radiofréquence généré par l'émetteur est fourni en entrée de l'amplificateur. La boucle de puissance comporte un circuit de détection ayant des moyens de couplage pour prélever une partie du signal de sortie de l'amplificateur de puissance. Ce signal radiofréquence prélevé, représentatif du signal de sortie, est redressé après passage dans une diode d'un bloc de détection en une tension continue dite de détection. Cette tension de détection est ensuite comparée, à l'aide d'un bloc comparateur placé en sortie du circuit de détection, à une tension de référence. Tant que la tension de référence n'est pas atteinte, le bloc comparateur influe sur l'amplificateur de puissance pour incrémenter la valeur de la puissance du signal de sortie.

Cependant, il arrive qu'un signal radiofréquence parasite circule dans l'émetteur dans un sens opposé au sens de propagation du signal de sortie. Par exemple, il peut s'agir de la puissance réfléchie par l'antenne désadaptée de l'émetteur, c'est-à-dire ayant un TOS (Taux d'Ondes Stationnaires) élevé. Ce signal parasite, également en partie prélevé via les moyens de couplage du circuit de détection, s'ajoute au signal prélevé du signal de sortie et crée des distorsions telles que la tension de détection n'est plus l'image du signal de sortie. Cette mauvaise détection fausse l'asservissement de l'amplificateur. Cela peut conduire soit à une consommation excessive de puissance de l'émetteur soit à une dégradation des performances de transmission du signal à émettre.

Dans l'art antérieur, certains émetteurs sont équipés d'un circulateur disposé en amont de la boucle de puissance par rapport au sens de propagation de la puissance réfléchie. Le circulateur est monodirectionnel : il autorise le passage du signal à émettre et supprime le signal réfléchi contrapropagatif.

Un tel circulateur est un composant onéreux. En outre, de part sa grande taille, il est difficilement intégrable dans certains émetteurs de dimensions réduites tels que les stations radiotéléphoniques portables.

Le document EP 0 790 503 A1 décrit un amplificateur de puissance dont le gain est commandé par une unité d'asservissement, et par la mesure d'une part, de la puissance du signal radio direct délivré par l'amplificateur, et d'autre part, de la puissance de la composante réfléchie par l'antenne.

L'objet de l'invention est de réaliser une boucle d'asservissement ayant un circuit de détection intégrant des moyens de contrôle de détection et en outre à moindre coût.

A cet effet, la présente invention propose une boucle d'asservissement en puissance selon la revendication 1.

Les moyens de contrôle selon l'invention sont intégrés dans le circuit de détection. Il n'est plus nécessaire d'employer un circulateur en amont de la boucle comme dans l'art antérieur.

Grâce aux moyens de déphasage selon l'invention, les composantes du signal parasite prélevé sont en opposition de phase et peuvent ainsi s'annuler au niveau de la branche de détection.

De préférence, les premiers et deuxièmes moyens de déphasage selon l'invention comportent chacun une inductance couplée avec une capacité.

Ainsi, les moyens de contrôle selon l'invention comportent des composants discrets peu onéreux, aisément intégrables dans des équipements portatifs et pouvant être ajoutés facilement dans des boucles déjà existantes.

Dans ce dernier mode de réalisation, la première branche de sortie peut comprendre une branche principale menant à la branche de détection et comportant une première desdites inductances ainsi qu'une branche secondaire comprenant une première desdites capacités entre un plan de masse et un point de liaison avec la branche principale associée. La deuxième branche de sortie peut en outre comprendre une branche principale menant à la branche de détection et comportant l'autre desdites capacités, sensiblement identique à la première capacité, ainsi qu'une branche secondaire comprenant l'autre desdites inductances, sensiblement identique à la première inductance, disposée entre un plan de masse et un point de liaison avec la branche principale associée.

Avantageusement, les moyens de contrôle de détection peuvent comprendre un atténuateur disposé dans l'une des branches de sortie afin d'égaliser plus facilement l'amplitude des deux composantes du signal parasite prélevé à supprimer.

De préférence, les moyens de couplage peuvent comprendre des moyens de déphasage aptes à déphaser les signaux radiofréquences prélevés.

La présente invention propose également un circuit d'amplification de signaux radiofréquences comprenant un amplificateur de puissance et une boucle d'asservissement en puissance dudit amplificateur telle que décrite précédemment.

La présente invention propose aussi un émetteur de signaux radiofréquences comprenant des moyens d'émission de signaux radiofréquences et équipé d'un circuit d'amplification tel que décrit précédemment.

De préférence, l'émetteur selon l'invention est choisi parmi le groupe des stations radiotéléphoniques portables, des assistants numériques personnels et des ordinateurs portables

Une station radiotéléphonique portable selon l'invention peut être un téléphone cellulaire de type GSM, DCS (Digital Communication System en anglais) ou UMTS (Universal Mobile Telecommunications System en anglais), ou encore un téléphone de type DECT (Digital European Cordless Telecommunications en anglais).

L'invention sera mieux comprise à la lecture de la description qui suit et à l'examen des figures qui l'accompagne. Celles-ci ne sont présentées qu'à titre indicatif et nullement limitatif de l'invention. Dans ces figures :

- la figure 1 montre un mode de réalisation d'un circuit de détection d'une boucle de puissance selon l'invention ;
- la figure 2 montre un mode de réalisation d'un circuit d'amplification selon l'invention;
- la figure 3 montre un mode de réalisation d'un terminal radiotéléphonique portable selon l'invention.

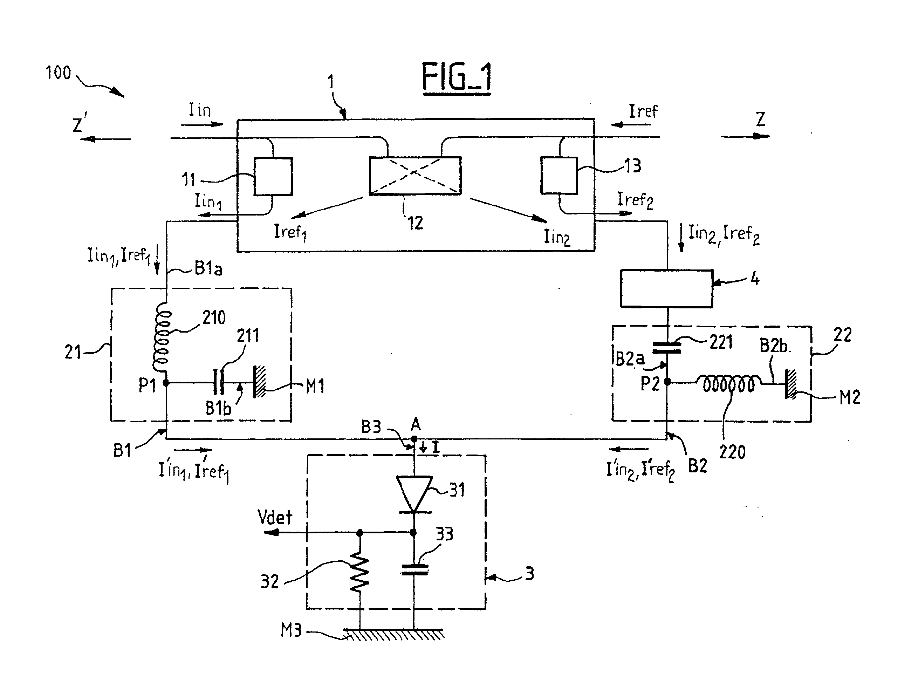

La figure 1 montre un mode de réalisation d'un circuit de détection 100 d'une boucle de puissance selon l'invention.

Le circuit de détection 100 comprend :

- des moyens de couplage 1, de type coupleur directif hybride, avec des moyens de déphasage 11, 12, 13 pour prélever des signaux radiofréquences via un facteur de prélèvement adapté $G_1$, $G_2$, $G_3$ respectivement et les déphaser de $\Delta\varphi_1$, $\Delta\varphi_2$ et $\Delta\varphi_3$ respectivement,
- des première et deuxième branches dites de sortie B1, B2 respectivement, interconnectées à un point d'interconnexion A sur une branche B3 dite de détection comprenant un bloc de détection 3 comportant une diode de redressement 31 reliée à une résistance 32 et à une capacité 33 en parallèle et mises à un plan de masse M3,
- des moyens de contrôle de détection comportant :

  - des premiers moyens de déphasage 21, insérés dans la première branche de sortie B1, pour déphaser des signaux radiofréquences de $-\Delta\varphi_0$ et des deuxièmes moyens de déphasage 22 insérés dans la deuxième branche de sortie B2, pour déphaser des signaux radiofréquences de $\Delta\varphi_0$, chacun des moyens 21, 22 comportant une inductance 210, 220 couplée avec une capacité 211, 221,
  - un atténuateur 4 ayant un facteur d'atténuation adapté $G_4$ disposé par exemple dans la deuxième branche de sortie B2 entre les deuxième moyens 22 et les moyens de couplage 1.

Plus précisément, la première branche de sortie B1 comprend une branche principale B1a comportant la première inductance 210 et menant à la branche de détection B3 au point d'interconnexion A ainsi qu'une branche secondaire B1b comprenant la première capacité 211 entre un plan de masse M1 et un point de liaison P1 avec la branche principale associée B1a. De même, la deuxième branche de sortie B2 comprend une branche principale B2a comportant la capacité 221, sensiblement identique à la première capacité 211, et menant à la branche de détection B3 au point d'interconnexion A ainsi qu'une branche secondaire B2b comprenant l'autre inductance 220, sensiblement identique à la première inductance 210, disposée entre un plan de masse M2 et un point de liaison P2 avec la branche principale associée B2a.

Décrivons maintenant le fonctionnement dynamique de la boucle à partir du trajet d'un courant radiofréquence de puissance dit incident Iin issu d'un amplificateur de puissance (non représenté) et se propageant suivant l'axe Z et du trajet d'un courant radiofréquence parasite de puissance Iref, par exemple courant réfléchi d'une antenne (non représentée) et se propageant selon l'axe Z'.

En entrée de la branche de sortie B2a, la composante $Iin_1$ du courant incident prélevé et la composante $Iref_1$ du courant réfléchi prélevé s'écrivent respectivement :

$$Iin_1 = G_1 \times Iin\ e(j\Delta\varphi_1)$$

$$Iref_1 = G_2 \times Iref\ e(j\Delta\varphi_2)$$

En sortie des premiers moyens de déphasage 21, ces courants deviennent :

$$I'in_1 = G_1 \times Iin\ e(j\Delta\varphi_1 - \Delta\varphi_0)$$

$$I'ref_1 = G_2 \times Iref\ e(j\Delta\varphi_2 - \Delta\varphi_0)$$

En entrée de la branche de sortie B2b, la composante $Iin_2$ du courant incident prélevé et la composante $Iref_2$ du courant réfléchi prélevé s'écrivent respectivement :

$$Iin_2 = G_2 \times Iin\ e(j\Delta\varphi_2)$$

$$Iref_2 = G_3 \times Iref\ e(j\Delta\varphi_3)$$

Après passage dans l'atténuateur 4 et les deuxièmes moyens de déphasage 21, ces courants deviennent :

$$I'in_2 = G_4 \times G_2 \times Iin\ e(j\Delta\varphi_2 + \Delta\varphi_0)$$

$$I'ref_2 = G_4 \times G_3 \times Iref\ e(j\Delta\varphi_3 + \Delta\varphi_0)$$

Au niveau du point A, le courant total I peut s'écrire :

$$
\begin{aligned}
I &= I'ref_1 + I'ref_2 + I'in_1 + I'in_2 \\
&= Iref\ [G_4 \times G_3\ e(j\Delta\varphi_3 + \Delta\varphi_0) + G_2\ e(j\Delta\varphi_2 - \Delta\varphi_0)] \\
&\quad + Iin\ [G_4 \times G_2\ e(j\Delta\varphi_2 + \Delta\varphi_0) + G_1\ e(j\Delta\varphi_1 - \Delta\varphi_0)]
\end{aligned}
$$

De manière générale, $G_4$ est choisi pour satisfaire à la condition d'égalisation des amplitudes des composantes $I'ref_1$, $I'ref_2$, du courant réfléchi prélevé, au niveau du point A, condition donnée par la formule :

$$G_4 \times G_3 = G_2$$

Il vient : $G_4 = G_2/G_3$.
De préférence, on choisit $G_3$ entre -10 dB et -14 dB et $G_2$ vaut entre -20 dB et -25 dB. Par exemple, pour G3 = -10 dB et G2 = -20 dB, $G_4$ vaut -10 dB.
Parallèlement, $\Delta\varphi_0$ est choisi pour satisfaire à la condition de mise en opposition de phase des composantes $I'ref_1$, $I'ref_2$, du courant réfléchi prélevé, au niveau du point A, condition donnée par la formule :

$$(\Delta\varphi_3 + \Delta\varphi_0) - (\Delta\varphi_2 - \Delta\varphi_0) = \pi$$

De préférence on choisit $\Delta\varphi_1=\Delta\varphi_3= 0$ et $\Delta\varphi_2=\pi/2$ car ce sont les propriétés des coupleurs usuels.

On obtient donc : $\Delta\varphi_0=\pi/4$

Ainsi, on ajuste les valeurs d'inductance et de capacité donnant un tel déphasage dans le domaine radiofréquence de fonctionnement de la boucle. Par exemple, dans la bande de fréquences radiotéléphoniques couramment utilisée (900 MHz ou 1800 MHz par exemple) ces valeurs de capacités sont de l'ordre 10 pF et les valeurs d'inductance de 5 nH.

Pour ces valeurs choisies de déphasage des moyens 11, 12, 13, 21, 22, les composantes $l'in_1$, $l'in_2$ du courant incident prélevé, au niveau du point A, sont aussi en opposition de phase. $G_1 \neq G_2$ est alors une condition nécessaire supplémentaire à réaliser pour ne pas annuler le courant incident prélevé. Dans la pratique, $G_1$ est toujours choisi très supérieur à $G_2$ car c'est une propriété des coupleurs utilisés dans les Radiotéléphones.

Finalement, le courant total I devient :

$$I = Iin [G_2{}^2 \times G_1{}^{-1} e(j3\pi/4) + G_1 e(-\pi/4)]$$

La composante $l'in_1$ d'amplitude $G_2{}^2 \times G_1{}^{-1}$ est négligeable par rapport à la composante $l'in_2$ d'amplitude $G_1$ du fait de $G_1 \gg G_2$.

On choisit par exemple $G_1$ égal à $G_3$.

Le courant total I est redressé après passage dans la diode 31 en une tension continue de détection Vdet :

$$Vdet = K \times I^2 = K \times Iin^2 \times [G_2{}^2 \times G_3{}^{-1} e(j3\pi/4) + G_3 e(-\pi/4)]^2$$

Grâce aux moyens selon l'invention, cette tension est bien représentative du courant incident prélévé : le circuit de détection 100 est donc performant.

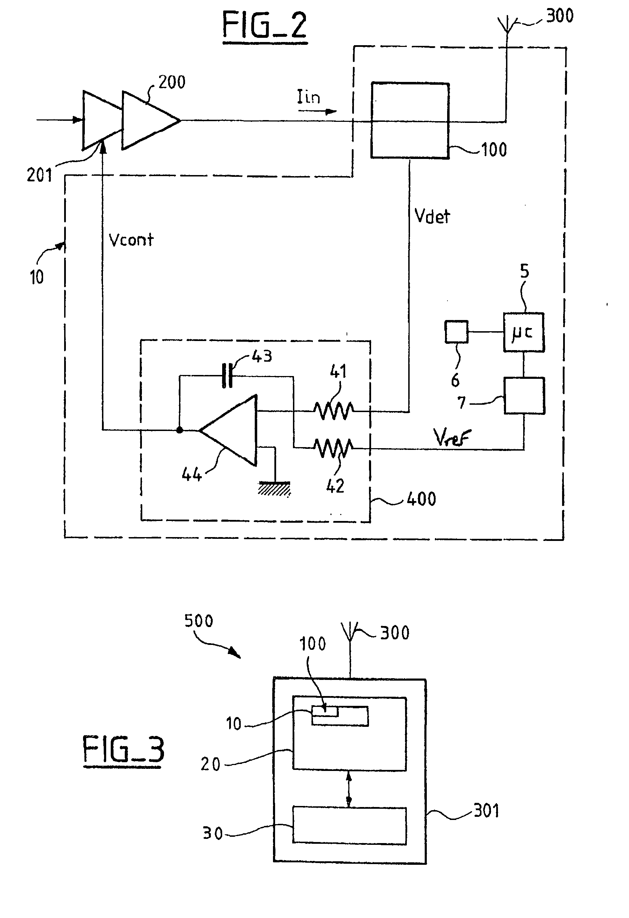

La figure 2 montre un mode de réalisation d'un circuit d'amplification selon l'invention contenant une boucle d'asservissement en puissance selon l'invention 10 avec le circuit de détection 100 tel que décrit en figure 1 et un amplificateur 200.

Un amplificateur de puissance 200, par exemple un transistor de fonctionnement non linéaire, reçoit un courant radiofréquence de puissance destiné à être amplifié. Ce courant provient de blocs de traitement en amont. Dans le cadre d'un téléphone de type GSM, la parole, transmise en ondes acoustiques, est convertie en un courant analogique puis numérique. Celui-ci subit une modulation en phase et éventuellement en amplitude grâce à un modulateur (non représenté). Ce courant doit, comme on l'a vu précédemment, subir une amplification de puissance de manière à pouvoir être reçu par la station de base communicante, non représentée. En sortie d'un tel modulateur, le courant est préamplifié par un préamplificateur (non représenté).

Le courant lin de sortie de l'amplificateur 200 est alors dirigé vers une antenne 300 pour la liaison vers la station de base correspondante.

Une fraction de ce signal est prélevée par le circuit de détection 100.

La boucle de puissance 10 est également branchée à une entrée 201 de l'amplificateur 200, entrée recevant le contrôle de la tension de polarisation de l'amplificateur.

En sortie du bloc de détection (voir figure 1) du circuit 100, intervient une tension de détection Vdet délivrée à une entrée d'un bloc comparateur 400 connu en soi.

Ce bloc 400 comprend classiquement deux résistances 41 42, chacune respectivement reliée à une borne d'entrée d'un amplificateur opérationnel 44. Une capacité 43 est montée en parallèle, une de ses extrémités étant reliée à la première résistance 41 elle-même en sortie du bloc de détection et son autre extrémité étant reliée à la sortie de l'amplificateur opérationnel 200. La seconde résistance 42 est reliée, à son autre extrémité, à une seconde borne d'entrée du bloc comparateur 400. Cette seconde borne d'entrée est reliée à une sortie d'un convertisseur 7 numérique-analogique dont l'entrée est reliée à une sortie d'un microcontrôleur 5. Celui-ci est également relié à une mémoire 6.

La sortie de l'amplificateur 200 est reliée à la sortie du bloc comparateur 400. Celle-ci est branchée à l'entrée 201 de contrôle de la tension de polarisation de l'amplificateur de puissance 200.

L'ajustement de la puissance de sortie à effectuer est géré par le microcontrôleur 5. La mémoire 6 comporte une table de correspondance qui fait correspondre une pluralité de valeurs de puissance à émettre (33 dBm par exemple) avec une pluralité respective de valeurs numériques. Ainsi, à la puissance à émettre de 33 dBm correspond une valeur numérique prédéterminée. Cette valeur est convertie en un signal analogique de référence par le convertisseur 7 appliquant une tension Vref de référence à l'une des bornes d'entrée du bloc comparateur 400.

Tant que la tension Vdet en sortie du bloc de détection est inférieure à Vref sur la première borne de l'amplificateur opérationnel 44, le bloc comparateur 400 délivre une tension continue positive et croissante de manière à pouvoir jouer sur la tension de polarisation de l'amplificateur 200. La tension Vdet évolue donc jusqu'à atteindre Vref.

Le bloc comparateur 400 est donc agencé dans la boucle de puissance 10 pour ajuster à la puissance désirée.

La figure 3 montre un mode de réalisation d'un terminal radiotéléphonique portable selon l'invention 500, de type GSM par exemple, contenant une antenne 300 et un boîtier 301 avec des moyens d'émission 30 de signaux radiofréquences modulés reliés à un circuit d'amplification 20 selon l'invention tel que décrit en figure 2 et comportant une boucle d'asservissement en puissance 10 avec un circuit de détection 100 tel que décrit en figure 1.

Bien entendu, l'invention n'est pas limitée aux modes de réalisation décrits ci-dessus.

Les valeurs données des paramètres de déphasages et des facteurs de prélèvement et d'atténuation sont données à titre indicatif tout comme l'emplacement de l'atténuateur.

En outre, l'antenne du terminal portable selon l'invention peut aussi bien être insérée dans le boîtier du terminal.

## Revendications

**1.** Boucle d'asservissement en puissance (10), pour commander un amplificateur de puissance (200) notamment, comprenant un circuit de détection (100) comportant :

- des moyens de couplage (1) pour prélever des signaux radiofréquences,
- un bloc de détection (3) pour délivrer un signal de détection (Vdet) partiellement représentatif d'un premier signal radiofréquence (Iin) prélevé par les moyens de couplage,

**caractérisée en ce que** le circuit de détection (100) comprend,-entre les moyens de couplage (1) et le bloc de détection (3), des moyens de contrôle de détection (21, 22, 4) pour supprimer sensiblement un deuxième signal radiofréquence (Iref) dit signal parasite correspondant au premier signal réfléchi et prélevé par les moyens de couplage (1), de sorte que le signal de détection (Vdet) est totalement représentatif du seul premier signal radiofréquence (Iin), lesdits moyens de contrôle de détection comprenant des premiers moyens de déphasage (21) insérés entre une première sortie des moyens de couplage (1) et une première branche de sortie (B1), des deuxièmes moyens de déphasage (22) insérés entre une deuxième sortie des moyens de couplage (1) et une deuxième branche de sortie (B2), les première et deuxième branches de sortie (B1, B2) étant interconnectées sur une branche détection (B3) comportant le bloc de détection (3) et prélevant chacune une composante (Iref1, Iref2) du deuxième signal radiofréquence (Iref), les premiers, les premiers et deuxièmes moyens de déphasage (21, 22) étant ajustés pour induire des déphasages sensiblement opposés sur lesdites composantes (Iref1, Iref2).

**2.** Boucle d'asservissement en puissance (10) selon la revendication 1 **caractérisée en ce que** les premiers et deuxièmes moyens de déphasage (21, 22) comportent chacun une inductance (210, 220) couplée avec une capacité (211, 221).

**3.** Boucle d'asservissement en puissance (10) selon la revendication 2 **caractérisée en ce que** la première branche de sortie (B1) comprend une branche principale (B1a) menant à la branche de détection (B3) et comportant une première desdites inductances (210) ainsi qu'une branche secondaire (B1b) comprenant une première desdites capacités (211) entre un plan de masse (M1) et un point de liaison (P1) avec la branche principale associée, et **en ce que** la deuxième branche de sortie (B2) comprend une branche principale (B2a) menant à la branche de détection (B3) et comportant l'autre desdites capacités (221), sensiblement identique à la première capacité (211), ainsi qu'une branche secondaire (B2b) comprenant l'autre desdites inductances (220), sensiblement identique à la première inductance (210), disposée entre un plan de masse (M2) et un point de liaison (P2) avec la branche principale associée.

**4.** Boucle d'asservissement en puissance (10) selon l'une des revendications 1 à 3 **caractérisée en ce que** les moyens de contrôle de détection comprennent un atténuateur (4) disposé dans l'une des branches de sortie (B2a).

**5.** Boucle d'asservissement en puissance (10) selon l'une des revendications 1 à 4, **caractérisée en ce que** les moyens de couplage (1) comprennent des moyens de déphasage (11, 12, 13) aptes à déphaser les signaux radiofréquences prélevés.

**6.** Circuit d'amplification (20) de signaux radiofréquences comprenant un amplificateur de puissance (200) et une boucle d'asservissement en puissance (10) dudit amplificateur selon l'une des revendications précédentes.

**7.** Emetteur de signaux radiofréquences (500) comprenant des moyens d'émission de signaux radiofréquences (30) et équipé d'un circuit d'amplification ( 20) de signaux radiofréquences selon la revendication 6.

**8.** Emetteur (500) selon la revendication 7, **caractérisé en ce qu'**il est choisi parmi le groupe des stations radiotéléphoniques portables, des assistants numériques personnels et des ordinateurs portables.

**Claims**

**1.** Power feedback loop (10), to control a power amplifier (200) in particular, comprising a detection circuit (100) including:

- means of coupling (1) to sample the radio frequency signals,
- a detection unit (3) to deliver a detection signal (Vdet) partially representative of a first radio frequency signal (Iin) sampled via the means of coupling,

**characterised in that** the detection circuit (100) comprises, between the means of coupling (1) and the detection unit (3), means of detection control (21, 22, 4) for perceptibly cancelling a second radio frequency signal (Iref), known as a parasite signal, corresponding to the first reflected signal and sampled via the means of coupling (1), such that the detection signal (Vdet) is fully representative of only the first radio frequency signal (Iin), said means of detection control including first means of phase shifting (21) inserted between a first output of the means of coupling (1) and a first output branch (B1), the two means of phase shifting (22) inserted between a second output of the means of coupling (1) and a second output branch (B2), the first and second output branches (B1, B2) being interconnected on a detection branch (B3) comprising the detection unit (3) and each sampling a component (Iref1, Iref2) of the second radio frequency signal (Iref), the first, the first and second means of phase shifting (21, 22) being adjusted to induce perceptibly opposite phase shifts on said components (Iref1, Iref2).

**2.** Power feedback loop (10) according to claim 1, **characterised in that** the first and second means of phase shifting (21, 22) each comprise an inductor (210, 220) coupled to a capacitor (211, 221).

**3.** Power feedback loop (10) according to claim 2, **characterised in that** the first output branch (B1) comprises a principal branch (B1a) leading to the detection branch (B3) and including a first of said inductors (210) as well as a secondary branch (B1b) including a first of said capacitors (211) between a earth layer (M1) and a connection point (P1) with the associated first branch,

and **in that** the second output branch (B2) comprises a principal branch (B2a) leading to the detection branch (B3) and including the other of said capacitors (221), substantially identical to the first capacitor (211), as well as a secondary branch (B2b) including the other of said inductors (220), substantially identical to the first inductor (210), arranged between an earth layer (M2) and a connection point (P2) with the associated principal branch.

**4.** Power feedback loop (10) according to one of claims 1 to 3, **characterised in that** the means of detection control comprises an attenuator (4) located in one of the output branches (B2a).

**5.** Power feedback loop (10) according to one of claims 1 to 4, **characterised in that** the means of coupling (1) comprises means of phase shifting (11, 12, 13) suitable for phase shifting the radio frequency signals sampled.

**6.** Amplification circuit (20) of radio frequency signals comprising a power amplifier (200) and a power feedback loop (10) of said amplifier according to one of the preceding claims.

**7.** Emitter of radio frequency signals (500) comprising means for the emission of radio frequency signals (30) and equipped with a radio frequency signal amplification circuit (20) according to claim 6.

**8.** Emitter (500) according to claim 7, **characterised in that** it is selected from among the group of mobile radio telephone stations, personal digital assistants and portable computers.

**Patentansprüche**

1. Leistungs-Rückkoppelschleife (10), um insbesondere einen Leistungsverstärker (200) zu steuern, umfassend eine Detektionsschaltung (100), darin eingeschlossen:

   - Kupplungsmittel (1), um die Radiofrequenzsignale abzutasten,
   - eine Detektionseinheit (3), um ein Detektionssignal (Vdet) abzugeben, das teilweise repräsentativ für ein erstes Radiofrequenzsignal (Iin) ist, das über die Kupplungsmittel abgetastet wurde,

   **dadurch gekennzeichnet, dass** die Detektionsschaltung (100) zwischen dem Kupplungsmittel (1) und der Detektionseinheit (3) Mittel der Detektionssteuerung (21, 22, 4) umfasst, um wahrnehmbar ein zweites Radiofrequenzsignal (Iref), bekannt als Störsignal, zu löschen, entsprechend dem ersten reflektierten Signal und abgetastet über das Kopplungsmittel (1), so dass das Detektionssignal (Vdet) nur das erste Radiofrequenzsignal (Iin) vollständig repräsentiert, wobei das Mittel zur Detektionssteuerung erste Mittel zur Phasenverschiebung (21), eingefügt zwischen einem ersten Ausgang des Kopplungsmittels (1) und einem ersten Ausgangszweig (B1), die zwei Mittel der Phasenverschiebung (22), eingefügt zwischen einem zweiten Ausgang des Kopplungsmittels (1) und einem zweiten Ausgangszweig (B2), umfasst, wobei der erste und der zweite Ausgangszweig (B1, B2) auf einem Detektionszweig (B3) verbunden sind, umfassend die Detektionseinheit (3) und jeweils eine Komponente (Iref1, Iref2) des zweiten Radiofrequenzsignals (Iref) abtastend, wobei das erste, das erste und das zweite Mittel der Phasenverschiebung (21, 22) angepasst sind, um wahrnehmbar entgegengesetzte Phasenverschiebungen auf die Komponenten (Iref1, Iref2) zu induzieren.

2. Leistungs-Rückkoppelschleife (10) nach Anspruch 1, **dadurch gekennzeichnet, dass** das erste und das zweite Mittel zur Phasenverschiebung (21, 22) jeweils einen Induktor (210, 220) umfasst, der mit einem Kondensator gekoppelt ist (211, 221).

3. Leistungs-Rückkoppelschleife (10) nach Anspruch 2, **dadurch gekennzeichnet, dass** der erste Ausgangszweig (B1) einen Hauptzweig (B1a) umfasst, der zum Detektionszweig (B3) führt und einen ersten der Induktoren (210) einschließt, ebenso wie einen zweiten Zweig (B1b), der einen ersten der Kondensatoren (211) zwischen einer Erdschicht (M1) und einem Verbindungspunkt (P1) mit dem verbundenen ersten Zweig einschließt, und dadurch, dass der zweite Ausgangszweig (B2) einen Hauptzweig (B2a) umfasst, der zum Detektionszweig (B3) führt und den anderen der Kondensatoren (221) einschließt, der im Wesentlichen identisch mit dem ersten Kondensator ist (211), ebenso wie einen sekundären Zweig (B2b), der den anderen der Induktoren (220) einschließt, der im Wesentlichen identisch mit dem ersten Induktor (210) ist, der zwischen einer Erdschicht (M2) und einem Verbindungspunkt (P2) mit dem verbundenen Hauptzweig angeordnet ist.

4. Leistungs-Rückkoppelschleife (10) nach einem der Ansprüche 1 bis 3, **dadurch gekennzeichnet, dass** das Mittel der Detektionssteuerung ein Dämpfungsglied (4) umfasst, das sich in einem der Ausgangszweige (B2a) befindet.

5. Leistungs-Rückkoppelschleife (10) nach einem der Ansprüche 1 bis 4, **dadurch gekennzeichnet, dass** das Kupplungsmittel (1) Mittel der Phasenverschiebung (11, 12, 13) umfasst, die für die Phasenverschiebung des abgetasteten Radiofrequenzsignals geeignet sind.

6. Verstärkerschaltung (20) von Radiofrequenzsignalen, umfassend einen Leistungsverstärker (200) und eine Leistungs-Rückkoppelschleife (10) des Verstärkers nach einem der vorherigen Ansprüche.

7. Sender von Radiofrequenzsignalen (500), umfassend Mittel zum Senden von Radiofrequenzsignalen (30) und ausgestattet mit einer Radiofrequenzsignal-Verstärkerschaltung (20) nach Anspruch 6.

8. Sender (500) nach Anspruch 7, **dadurch gekennzeichnet, dass** er aus einer Gruppe von Mobilfunk-Telefonstationen, persönlichen digitalen Assistenten und tragbaren Computern ausgewählt ist.

FIG_1

## FIG_2

## FIG_3

**EP 1 337 038 B1**